# EUROPEAN PATENT APPLICATION

(11) **EP 0 810 664 A2**
(43) Date of publication of application: **03.12.1997**
(21) Application number: 97108607.9
(22) Date of filing: 28.05.1997
(51) Int. Cl.: H01L 27/108, H01L 21/8242

(54) **DRAM cell and method of its manufacture**

(30) Priority: 31.05.1996 US 18763 P; 26.02.1997 US 39819 P
(71) Applicant: TEXAS INSTRUMENTS INCORPORATED, Dallas Texas 75265 (US)
(72) Inventor: Wise, Rick L., Plano, Texas 75025 (US)
(74) Representative: Schwepfinger, Karl-Heinz, Dipl.-Ing.

(57) **Abstract**

A dynamic random access memory cell (20) with increased capacitance and method of fabricating including forming an open box storage capacitor (21) having a void within (152). The method comprises forming on a substrate (22) a storage electrode (130) with a void (152) within and with an exterior surface through selective silicon deposition. A dielectric (148) is deposited within the void and on the exterior surface of the pillar. A second electrode (150) is formed by depositing a conductive material over the dielectric (148). The dynamic random access memory cell (20) has increased surface area to provide for the same or even greater capacitance as the overall size or volume of the memory cell is reduced.

## Description

### TECHNICAL FIELD OF THE INVENTION

This invention relates generally to integrated circuit, and more particularly to a method of fabricating a dynamic random access memory with increased capacitance.

### BACKGROUND OF THE INVENTION

Dynamic random access memory ("DRAM") cells typically consist of one transistor and one capacitor. One of the goals in the design of DRAMs is to increase the memory capacity on each integrated circuit. To increase the memory capacity, significant efforts have been made at decreasing the size of each of the memory cells that make up the DRAM. One of the most challenging problems faced by DRAM designers is the maintenance of sufficient charge-storage capacity in the capacitors of the memory cells as their size is decreased.

Important parameters involved in increasing the charge stored on the capacitor are typically the dielectric constant, thickness of the insulator, and surface area of the capacitor. Many techniques have been investigated for increasing the charge-storage capacity in capacitors without increasing the area (footprint) the DRAM cells occupy on a chip's surface or the size (volume) of the DRAM cell. One example is a trench capacitor in which the capacitor is formed as part of a trench in a substrate with the transistor disposed on the surface of the substrate. A trench capacitor may include a plate electrode of the capacitor inside the trench and a storage electrode on the substrate.

Another approach that allows a memory cell to shrink in size without a loss of its storage capacity is stacking the storage capacitor on top of the associated transistor. DRAM cells made through this process are sometimes called stacked capacitor DRAMs. Although stack capacitor DRAMs may reduce the planar surface area required by a capacitor, they are generally formed significantly above the surface of the substrate in which the DRAM cell is formed, which leads to topological problems in the formation of subsequent layers of the associated integrated circuit.

### SUMMARY OF THE INVENTION

Therefore, a need has arisen for a method of fabricating a DRAM cell that reduces the problems associated with previous capacitor structures, while maintaining sufficient storage capacity for the resulting capacitor.

In accordance with the present invention, disadvantages and problems associated with previous DRAM cells have been substantially reduced or eliminated. In accordance with teachings of the present invention, a DRAM cell with a storage capacitor having a storage electrode with increased surface area is provided. The dynamic random access memory cell includes a storage electrode defined in part by a void space and an exterior surface, a dielectric material deposited within the void space and on the exterior surface of the storage electrode, and a conductive material deposited over the dielectric material.

According to another embodiment of the present invention, a method of forming a dynamic random access memory cell having a storage capacitor in a substrate is provided. The method includes the steps of depositing at least one insulating layer on a substrate, forming a void in the insulating layer, and forming a capped pillar storage electrode. The step of forming a capped pillar storage electrode includes selectively depositing silicon within the void and overgrowing the silicon to form a capped pillar.

According to yet another embodiment of the present invention, a method for forming a semiconductor device having a substrate is provided. The method includes the steps of forming on the substrate a storage electrode having a void therein and also having an exterior surface. A dielectric is deposited within the void and on the exterior surface of the storage electrode, and a conductive material is deposited over the dielectric.

Important technical advantages of the present invention include significantly increasing the storage capacity of a storage electrode in a capacitor type DRAM cell by increasing the surface area of the storage electrode. An open box storage node embodiment of the present invention, approximately doubles the surface area of the resulting storage electrode. By increasing the surface area, the amount of charge that can be stored by the associated capacitor is increased without increasing the overall size of the DRAM cell or the footprint on the associated substrate. Thus, the present invention allows DRAM cells to further shrink in size while maintaining a sufficient amount of capacitance.

### BRIEF DESCRIPTION OF THE DRAWINGS

For a more complete understanding of the present invention, and the advantages thereof, reference is now made to the following descriptions taken in conjunction with the accompanying drawings, in which:
FIGURE 1 is a schematic drawing in section with portions broken away of a DRAM cell with an capped pillar storage capacitor fabricated according to the teachings of the present invention on a semiconductor substrate;
FIGURE 2 is a schematic drawing in section with portions broken away of a DRAM storage capacitor, during formation of an oxide layer and a nitride layer;
FIGURE 3 is a schematic drawing in section with portions broken away of a DRAM storage capacitor, during formation of a second oxide layer and a second nitride layer;
FIGURE 4 is a schematic drawing in section with portions broken away showing a portion of a DRAM memory cell showing the fabrication of the lower storage node after etching of the oxide and nitride layers;
FIGURE 5 is a drawing in section with portions broken away showing formation of a capped pillar capacitor by overgrowing selectively deposited silicon;
FIGURE 6 is a schematic drawing in section with portions broken away of the capped pillar storage capacitor fabricated according to the teachings of the present invention, after formation of a dielectric layer and a second electrode layer;
FIGURE 7 is a schematic drawing in section with portions broken away of a second embodiment of a DRAM storage capacitor, during formation of a third oxide layer and a third nitride layer;
FIGURE 8 is a schematic drawing in section with portions broken away of a DRAM storage capacitor during processing, after etching a trench or a trough in the third oxide and nitride layers;
FIGURE 9 is a top view of the etched trench or trough shown in FIGURE 8;
FIGURE 10 is a schematic drawing in section with portions broken away showing a portion of the DRAM capacitor of FIGURE 8, after selective deposition of silicon in the trench or trough shown in FIGURES 8 and 9;
FIGURE 11 is a schematic drawing in section with portions broken away of the lower electrode of a storage capacitor after removal of the second and third oxide and nitride layers;
FIGURE 12 is a schematic drawing in section with portions broken away of the storage capacitor after application of a layer of dielectric and a layer of polysilicon;
FIGURE 13 is a schematic drawing in section with portions broken away showing a completed storage capacitor fabricated according to the teachings of the present invention with rugged polysilicon deposited on the storage electrode; and
FIGURE 14 is a plan view of rugged polysilicon showing its contoured surface.

### DETAILED DESCRIPTION OF THE INVENTION

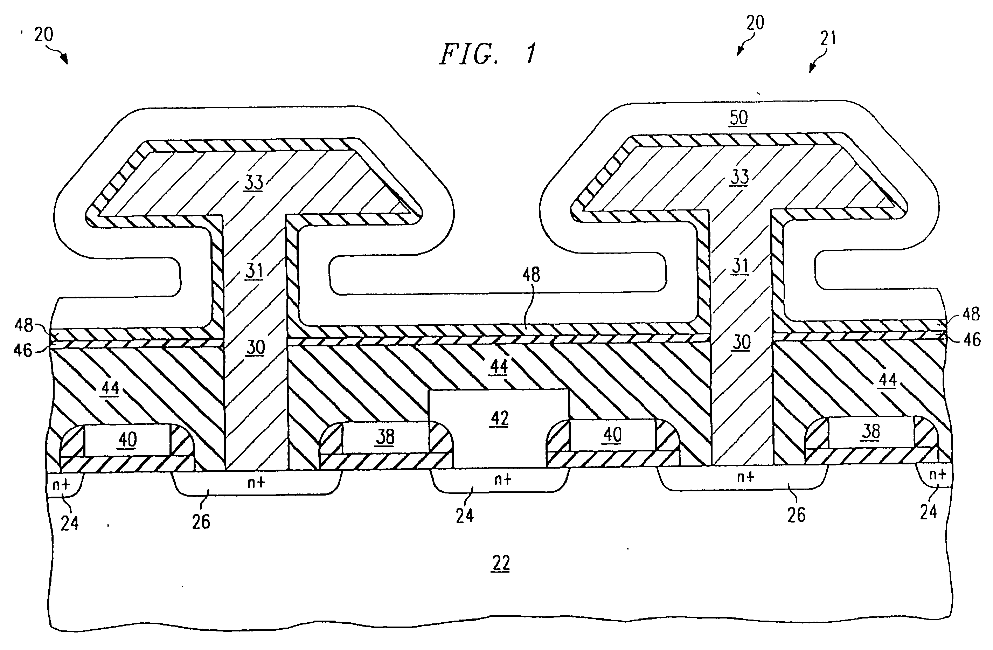

The preferred embodiments of the present invention and its advantages are best understood by referring to FIGURES 1-14 of the drawings, like numerals being used for like and corresponding parts of the various drawings.

FIGURE 1 shows two dynamic random access memory (DRAM) cells 20 disposed on semiconductor substrate 22 constructed according to the teachings of the present invention. Semiconductor substrate 22 is typically a p-type silicon substrate, although it should be understood that other substrates may be used without departing from the scope of the invention. Memory cells 20 are preferably dynamic random access memory cells. However, the present invention may be used to form a wide variety of memory cells and other electronic devices which require a relatively large amount of capacitance in a relatively small total volume.

Doped source regions 24 and doped drain regions 26 are shown in FIGURE 1. With a p-type substrate, source regions 24 and drain region 26 are typically doped with n-type impurities. Overlying gates 38 and 40 may be formed of doped polysilicon insulatively adjacent channel regions between source 24 and drain 26. A bit line 42 is electrically coupled to the source region 24 and insulatively adjacent to the gates 38 and 40. The gates 38 and 40 are typically control gates associated with access transistors (not expressly shown) that couple a storage electrode to bit line 42.

Overlying source region 24, drain region 26, gates 38 and 40, and bit line 42 is an oxide layer 44. Disposed on top of oxide layer 44 is a nitride layer 46. Extending through nitride layer 46 and oxide layer 44 to drain region 26 is first electrode or storage electrode 30. Storage electrode 30 includes a stem portion 31 and a capped portion 33. As will be discussed in more detail below, capped portion 33 provides an increase in surface area of storage electrode 30. The storage electrode 30 may be patterned to form separate storage electrodes for multiple memory cells. The storage electrode 30, may be formed of doped silicon and conductively coupled to the drain region 26 as shown in FIGURE 1. Dielectric material 48 is formed on the exterior surface of storage electrodes 30. Dielectric material 48 preferably forms a continuous layer of dielectric that may extend to adjoining storage electrodes, as shown in FIGURE 1. Second electrode 50 is formed on the exterior of dielectric material 48, and may also extend to the adjoining storage electrode.

Although the present invention is described in the context of a DRAM shown in FIGURE 1, it should be understood that various modifications, alterations, and substitutions can be made without departing from the intended scope of the present invention, including the formation of semiconductor devices having capacitors that are not DRAMS.

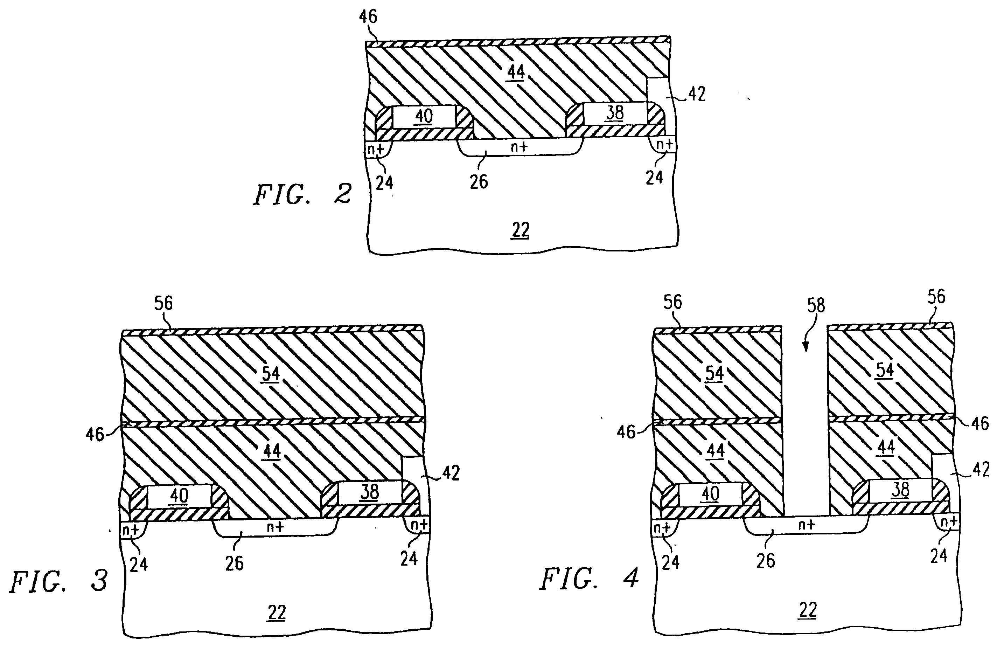

The fabrication of storage electrode 30 will be explained with reference to FIGURES 1-6. After formation of sources 24, drains 26, gates 38 and 40, and bit line 42, which may be constructed according to teachings well known in the art, an insulating layer, such as oxide layer 44, is placed over these elements. In addition, a masking layer, such as nitride layer 46, is placed over oxide layer 44. An enlarged view of the nitride layer 46 and the oxide layer 44 overlying drain region 26 is shown in FIGURE 2. As illustrated in FIGURE 3, a second insulating layer, such as second oxide layer 54, is disposed on top of nitride layer 46 and a second masking layer, such as second nitride layer 56, is placed over the second oxide layer 54.

As shown in FIGURE 4, a void region 58 is etched through to the drain region 26 after patterning an area in nitride layer 56 and oxide layer 54 (not explicitly shown). After patterning a similar area in first nitride layer 46, the remainder of void region 58 is etched through first oxide layer 44 to drain region 26. The etching is preferably an anisotropic etch. Nitride layers 46 and 56 provide a masking layer to facilitate selective etching of void region 58.

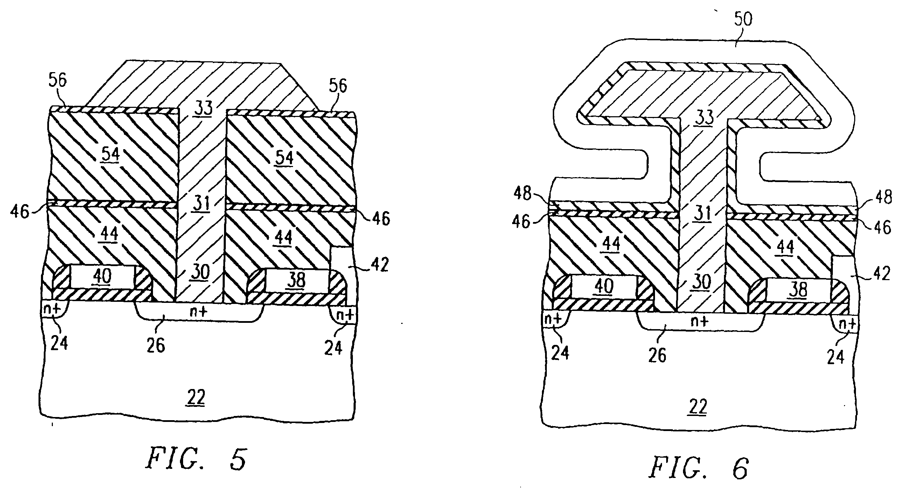

The next step in the fabrication of storage node 30 is illustrated in FIGURE 5. Doped silicon is selectively deposited in void region 58 to form stem portion 31. The doped silicon may be polysilicon and preferably has a doping level somewhere in the region of 1-5 x 10²⁰ atoms per cubic centimeter of phosphorous, although other doping levels and dopants may be used. Other doping levels, including the range of 5 x 10¹⁹ to 1 x 10²¹ atoms per cubic centimeter, are within the scope of the teachings of the present invention. Additional doping levels outside the range explicitly stated are also within the scope of the present invention. A variety of dopants may be used, such as phosphorous, arsenic, boron, and others apparent to those skilled in the art without departing from the teachings of the present invention. Selective silicon deposition allows the growth of the doped silicon only on silicon. Selective silicon deposition is well known in the art, however, the chemical reactions associated with the use of dichlorosilane for selective silicon deposition are given below.

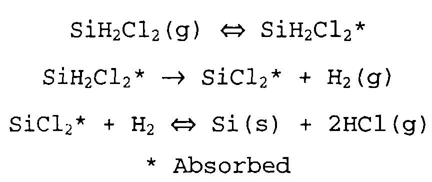

For these particular chemical reactions, additional HCl may be added to eliminate formulation of nuclei on the dielectric or masking layer surfaces.

By overgrowing the silicon over the second nitride layer 56, a capped portion 33 of storage electrode 30 is formed, as shown in FIGURE 5. This capped pillar embodiment increases the effective surface area of storage node 30 by approximately 15-20 percent.

After formation of storage electrode 30, second oxide layer 54 and second nitride layer 56 are removed. An isotropic etch may be used for this removal. As shown in FIGURE 6, a dielectric material 48 is formed on the capped portion 33 of storage electrode 30, and on the stem portion 31. The dielectric may extend along the surface of nitride layer 46 to the storage electrode in the adjacent memory cell. On top of dielectric layer 48, a layer of silicon, which may be polysilicon is placed, which constitutes the second electrode 50 of storage capacitor 21. This layer of polysilicon may also extend to the adjacent memory cell.

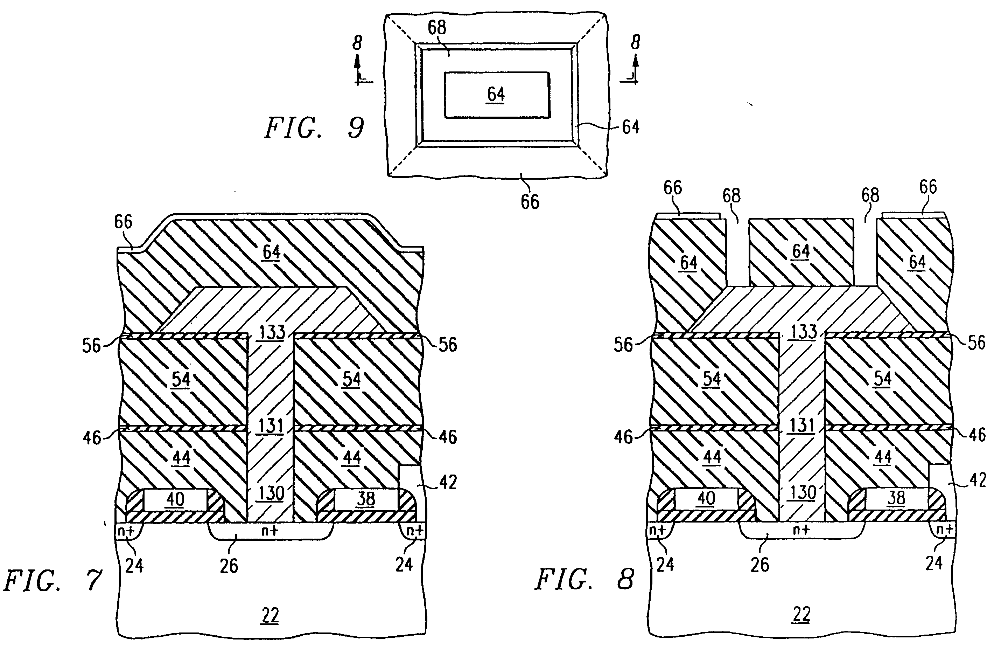

The surface area of lower electrode 30 may be further enhanced as described in conjunction with FIGURES 7-12. As shown in FIGURE 7, after formation of lower electrode 130, as described in FIGURE 5, instead of applying layers of dielectric 48 and polysilicon 50, an additional insulating layer 64, such as oxide, is applied over storage electrode 30. In addition, an additional masking layer, such as nitride, 66 is applied over oxide layer 64. A trench or trough 68 is then formed extending down to the storage electrode 130 (FIGURE 8). As more clearly illustrated in FIGURE 9, trench or trough 68 forms a geometric pattern in oxide layer 64. Although the cross-section of trench or trough region 68 is shown in FIGURES 8 and 9 to be generally rectangular, it is to be understood that a variety of geometrical patterns could be formed such as a circle, square or other geometric pattern without departing from the scope of the present invention.

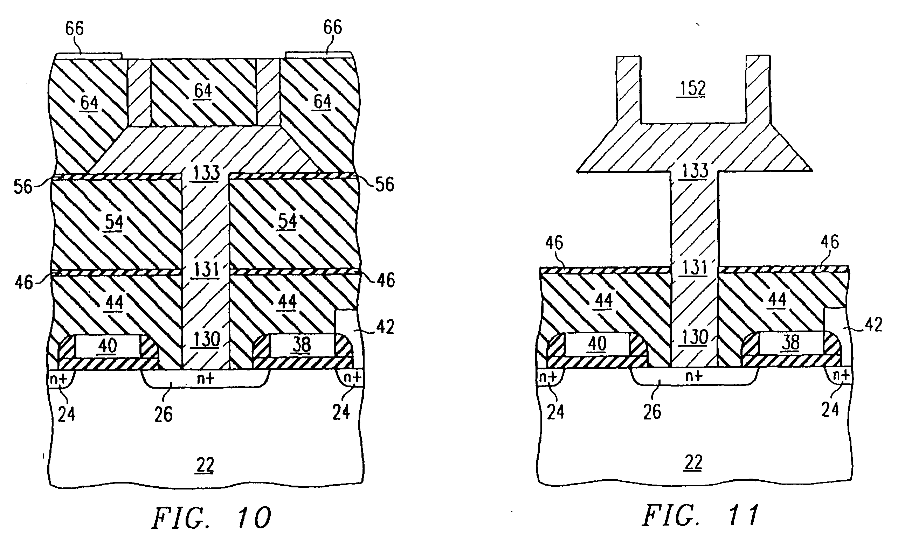

After formation of trench or trough 68, the next step in the formation of storage electrode 30 is to selectively deposit silicon in the trench or trough region 68. The selective deposition of silicon is as described above with reference to the embodiment of this invention shown in FIGURES 1-6. After selective silicon deposition in trough or trench region 68, an isotropic etch is performed that removes nitride layers 56 and 66 and oxide layers 54 and 64, which leaves the open-box configuration shown in FIGURE 11 having a void region 152. One advantage of the open-box structure is that it has both an interior and exterior surface over which a dielectric may be applied. Therefore, the surface area of storage node 130 is significantly enhanced, thereby increasing its memory capacity. Although the configuration of the open-box portion of storage electrode 130 is shown to be generally rectangular, it is to be understood that a variety of geometric patterns may be formed without departing from the teachings of the present invention.

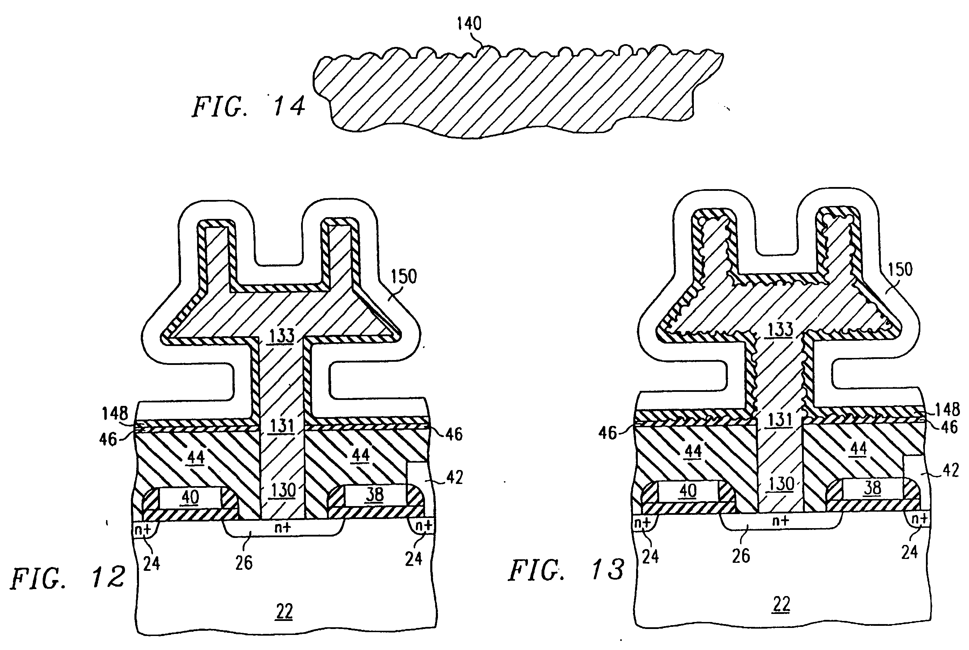

In FIGURE 12, dielectric material 148 is formed on storage electrode 130. Dielectric 148 also fills the void 152. On top of dielectric layer 148, a layer 150 of polysilicon is placed, which constitutes the second electrode. Since dielectric 148 is in contact with storage electrode 30, both in the void 152 and on the exterior surface of the electrode 30, the effective surface area of the storage electrode is significantly enhanced. As with the embodiment shown in FIGURES 1-6, both the dielectric layer 148 and the second electrode may extend to the adjacent memory cell.

To further enhance the surface area of the storage electrode 30, 130, a layer of rugged polysilicon 154 may be applied to the surface of storage electrode 30, 130 prior to applying dielectric 48, 148 as shown in FIGURES 13-14. The rugged polysilicon is deposited over both the insulating layer 46 and the storage node 130 and then anisotropically etched, as shown in FIGURE 13, before deposition of the dielectric. The anisotropic etch leaves rugged polysilicon on the storage electrode, including the sides of the stem portion 133 and the first insulating layer 46 beneath the capped portion 133.

Application of rugged polysilicon is a well known process in the art. At certain temperatures and pressures, deposition of polysilicon forms nodules on the surface and as arriving silicon atoms reach the surface, they migrate across the surface to form one of the nodules forming what is called rugged polysilicon or hemispherical grain polysilicon, as shown best in FIGURE 14. This is in contrast to a smooth continuous film which is provided with standard polysilicon. Rugged polysilicon is known to produce a surface area of approximately 2.2 times that of smooth silicon. Rugged polysilicon may also be applied to the storage capacitor 30 in the embodiment shown in FIGURE 6 before application of the dielectric 48 and second electrode 50 to further enhance the surface area of storage electrode 30.

Although the present invention has been described in detail, it should be understood that various modifications, alterations, and substitutions can be made to this description without departing from the intended scope of the present invention.

## Claims

1. A dynamic random access memory cell having a storage capacitor disposed substantially on a surface of a substrate comprising:
a storage electrode defined in part by a void space and an exterior surface;
a dielectric material deposited substantially within the void space and on the exterior surface of the storage electrode; and
a conductive material deposited substantially over the dielectric material.

2. The memory cell of Claim 1, wherein the storage electrode is formed from selectively deposited silicon.

3. The memory cell of Claim 1 or Claim 2, wherein the storage electrode is formed in part from a layer of rugged polysilicon deposited on at least one layer of selectively deposited silicon.

4. The memory cell of any preceding claim, wherein the conductive material is formed from polysilicon.

5. The memory cell of any preceding claim further comprising at least one selectively deposited silicon layer doped in the range of 1x10²⁰ atoms/cm³ to 5 x 10²⁰ atoms/cm³ of phosphorous.

6. A method of forming a dynamic random access memory cell having a storage capacitor and a substrate comprising the steps of:
depositing at least one insulating layer on the substrate;
forming a void in at least one insulating layer;
forming a storage electrode in part by selectively depositing silicon within the void;
and overgrowing the selectively deposited silicon onto a portion of the insulating layer adjacent the void.

7. The method of Claim 6, wherein the step of forming a void in the at least one insulating layer further comprises the steps of:
applying at least one masking layer in a one to one fashion over the at least one insulating layer; and
anisotropically etching a void region in the at least one insulating layer and the at least one masking layer.

8. The method of Claim 7 wherein the step of forming a storage electrode further comprises overgrowing the selectively deposited silicon onto one of the at least one masking layer.

9. The method of any of Claims 6 to 8 further comprising the steps of:
depositing a dielectric onto the storage electrode; and
depositing a conductive material over the dielectric.

10. The method of any of Claims 6 to 9 further comprising the step of depositing rugged polysilicon on the selectively deposited silicon.

11. The method of any of Claims 6 to 10, wherein the step of forming the storage electrode comprises forming a capped pillar storage electrode.

12. The method of Claim 11 further comprising the step of removing a portion of at least one insulating layer after formation of the capped pillar.

13. The method of any of Claims 6 to 12, wherein the step of selectively depositing silicon comprises selectively depositing polysilicon doped in the range of 1 x 10²⁰ atoms/cm³ to 5 x 10²⁰ atoms/cm³ of phosphorous.

14. The method of any of Claims 6 to 13, wherein the step of depositing an insulating layer on the substrate comprises depositing an oxide on the substrate.

15. A method of forming a semiconductor device having a substrate, comprising the steps of:
forming a storage electrode on the substrate having a void therein;
depositing a dielectric within the void and on exterior surface of the storage electrode; and
depositing a conductive material over the dielectric.

16. The method of Claim 15, wherein the step of forming the storage electrode comprises the steps of:
depositing a first insulating layer on the substrate;
applying a first masking layer to at least a portion of the first insulating layer;
depositing a second insulating layer on the substrate;
applying a second masking layer to at least a portion of the first insulating layer;
forming a second void in the first and second insulating and the first and second masking layers;
selectively depositing silicon within the void;
depositing a third layer of insulating material over the selectively deposited silicon;
applying a third masking layer to at least a portion of the third layer of insulating material;
removing a first portion of the third layer of insulating material to form a trench, the trench surrounding a second portion of the third layer of insulating material; and
selectively depositing silicon within the trench.

17. The method of Claim 16, wherein the step of removing a first portion of the third layer of insulating material further comprises the step of anisotropically etching a trench in the insulating layer.

18. The method of any of Claims 15 to 17, wherein the step of selectively depositing silicon within the trench comprises selectively depositing doped silicon in the range of 1 x 10²⁰ atoms/cm³ to 5 x 10²⁰ atoms/cm³ of phosphorous.

19. The method of any of Claims 15 to 18, comprising the step of applying rugged polysilicon over the storage electrode.

20. The method of any of Claims 15 to 19, further comprising the steps of:
depositing a dielectric over the storage electrode; and
depositing a conductive material over the dielectric.

21. The method of any of Claims 16 to 20, wherein the step of selectively depositing silicon within the void further comprises forming a capped pillar by overgrowing the selectively deposited silicon.
